# DEMANDE DE BREVET EUROPEEN

(11) **EP 1 286 465 A1**
(43) Date de publication de la demande: **26.02.2003**
(21) Numéro de dépôt: 02356152.5
(22) Date de dépôt: 31.07.2002
(51) Int. Cl.: H03H 9/62, H03H 9/50, H03H 1/00

(54) **Composant microélectromécanique**

(30) Priorité: 06.08.2001 FR 0110495
(71) Demandeur: Memscap, 38926 Crolles (FR)
(72) Inventeur: Mhani, Ahmed, 38100 Grenoble (FR); Fedeli, Jean-Marc, 38120 Saint Egreve (FR)
(74) Mandataire: Vuillermoz, Bruno

(57) **Abrégé**

Composant microélectromécanique (1) assurant des fonctions de filtrage, réalisé sur un substrat (10) à base de matériau semi-conducteur, et comportant deux bornes d'entrée (7, 8) et deux bornes de sortie (26, 27), caractérisé en ce qu'il comporte également :
■ un bobinage métallique d'entrée (2), relié aux bornes d'entrée (7, 8), et apte à générer un champ magnétique lorsqu'il est parcouru par un courant ;
■ un équipage mobile (3), relié au substrat par au moins une portion déformable, et incluant au moins une région (11, 12) réalisée en un matériau ferromagnétique, ledit équipage mobile (3) étant apte à se déplacer sous l'effet de la force subie par la région (11) en matériau ferromagnétique engendrée par le champ magnétique généré par le bobinage d'entrée (2) ;
■ un organe de sortie (4) formant un capteur magnétique, relié aux bornes de sortie (26, 27) et apte à générer un signal de nature électrique qui est variable en fonction du déplacement de l'équipage mobile (3).

## Description

### Domaine technique

L'invention se rattache au domaine de la microélectronique, et plus précisément à celui des composants utilisés dans les gammes radiofréquences. Elle vise plus spécifiquement une nouvelle structure de filtres passifs utilisés dans les circuits électroniques, et réalisée à partir de systèmes microélectromécaniques connus sous l'appellation anglaise de "MEMS" pour "micro electromechanical systems".

### Techniques antérieures

Dans le domaine des télécommunications, divers types de filtres sont utilisés pour réaliser les fonctions de filtrage, notamment dans les étages de fonctionnant à la fréquence intermédiaire, ou dans des oscillateurs, ou bien encore dans d'autres types de fonction.

Parmi les différents filtres utilisés, on peut notamment citer les filtres à quartz, ainsi que les filtres à ondes sonores de surface, également connues sous l'abréviation "SAW" pour *"surface acoustic wave".* Ce type de filtre fonctionne en utilisant des phénomènes piézoélectriques. Ils sont appréciés pour leur fort coefficient de qualité, ainsi qu'une excellente stabilité, notamment de la fréquence de résonance vis à vis de la température et du vieillissement. Cependant, à cause de limitations technologiques, il est impossible d'augmenter de façon très importante le nombre de pôle d'un tel filtre. Ces mêmes contraintes technologiques rendent ce type de filtre très difficile à miniaturiser fortement.

On a également proposé de réaliser des filtres en technologies MEMS, qui fonctionnent sur la base de phénomènes électrostatiques.

Ainsi, de façon générale, un tel filtre utilise deux armatures fonctionnant tel qu'un condensateur. L'application d'une tension alternative fonction du signal d'entrée aux bornes de ce condensateur induit un déplacement de l'armature qui est mobile, et donc une variation de la capacité du condensateur, et par conséquent la variation d'un signal de sortie. Les deux armatures sont mobiles l'une par rapport à l'autre, et une partie du système agit comme organe de rappel pour s'opposer à la déformation générée par la variation du signal d'entrée. La fréquence propre de ce filtre est fonction de la géométrie de la structure, ainsi que de la tension de polarisation appliquée entre les armatures.

Plusieurs géométries ont déjà été envisagées pour des filtres fonctionnant à base de phénomènes électrostatiques.

Ainsi, il existe des filtres ou plus généralement des résonateurs dans lesquels l'armature mobile se déplace perpendiculairement au plan principal du substrat sur lequel est réalisé le microcomposant. Certains de ces résonateurs peuvent d'ailleurs être couplés entre eux pour assurer une meilleure performance. Un des inconvénients de ce type de résonateur est une certaine sensibilité aux variations de pression, qui nécessitent l'encapsulation des microcomposants sous vide ou sous très faible pression.

Un autre inconvénient est celui de nécessiter une tension de polarisation qui peut être relativement élevée, supérieure à la dizaine de volts pour obtenir les performances souhaitées.

On connaît par ailleurs, d'autres filtres fonctionnant à base de phénomènes électrostatiques, et dans lesquels l'armature mobile se déplace dans un plan parallèle au plan principal du substrat sur lequel est réalisé le microcomposant. Il en va ainsi pour les filtres dont les armatures sont formées par des peignes interdigités. Grâce à cette configuration, les surfaces en regard des autres armatures sont relativement importantes, ce qui permet d'obtenir des courses suffisantes avec des tensions de polarisation moins élevées que pour les solutions décrites ci-avant.

Néanmoins, ces solutions présentent certaines limitations. En effet, la fréquence propre d'un tel résonateur est fonction de la constance de raideur des moyens de rappel interposés entre les armatures, ainsi que de la masse de l'armature mobile. Ainsi, pour atteindre des fréquences de résonance élevées, il sera préférable d'augmenter la constante de raideur tout en diminuant la masse de l'armature mobile. Toutefois, l'emploi d'une constante de raideur élevée se traduit par une faible amplitude de déplacement de l'armature mobile, qui n'est pas toujours suffisante pour bien distinguer le signal généré du bruit. Un compromis reste donc à faire entre l'augmentation de la fréquence du filtre et l'amplitude du signal de sortie.

Un premier problème que se propose donc de résoudre l'invention est celui de l'augmentation des fréquences de résonance des filtres réalisés selon les technologies MEMS. Un autre problème que se propose de résoudre l'invention est celui de la nécessité de réaliser des packagings sous vide pour conserver une bonne stabilité du filtre et une fréquence de résonance élevée.

Un autre problème est celui de la compatibilité entre l'augmentation de la fréquence de résonance et le niveau de signal de sortie, observé sur les filtres en technologie MEMS, fonctionnant à base de phénomènes électrostatiques. Un autre problème que cherche à résoudre l'invention est celui de l'emploi de tensions de polarisation élevées qui engendrent des consommations relativement importantes, au détriment de l'autonomie, et qui induisent des contraintes d'isolation.

### Exposé de l'invention

L'invention concerne donc un composant microélectromécanique assurant des fonctions de filtrage, réalisé sur un substrat à base d'un matériau semi-conducteur, et comportant deux bornes d'entrée, deux bornes de sortie.

Conformément à l'invention, ce microcomposant comporte également :
■ un bobinage métallique d'entrée, relié aux bornes d'entrée, et apte à générer un champ magnétique lorsqu'il est parcouru par un courant ;
■ un équipage mobile, relié au substrat par au moins une portion déformabie, et incluant au moins une région réalisée en un matériau ferromagnétique, ledit équipage mobile étant apte à se déplacer sous l'effet de la force subie par la région en matériau ferromagnétique engendrée par le champ magnétique généré par le bobinage d'entrée ;
■ un organe de sortie formant un capteur magnétique, relié aux bornes de sortie et apte à générer un signal de nature électrique qui est variable en fonction du déplacement de l'équipage mobile.

Autrement dit, le filtre comprend une partie mobile qui est mise en mouvement sous l'action du champ magnétique généré par le bobinage d'entrée. L'énergie électrique du signal d'entrée est donc convertie en énergie mécanique au niveau de l'équipage mobile caractéristique. Cet équipage mobile excite un capteur magnétique qui génère un signal de sortie électrique, résultant du déplacement de l'équipage mobile. L'énergie mécanique de l'équipage mobile est donc convertie en énergie électrique au niveau du capteur formant l'étape de sortie du filtre.

En employant une conversion d'énergie électrique en énergie magnétique et vice versa, on améliore la sensibilité du filtre à des fréquences plus élevées, en comparaison avec des filtres fonctionnant sur des principes électrostatiques. En effet, on parvient à augmenter la fréquence de résonance en choisissant un rapport de la raideur des moyens de rappel sur la masse de l'équipage mobile qui est important. Bien que les amplitudes des oscillations mécaniques soient relativement faibles, on obtient toutefois un signal généré au niveau de l'état de sortie, qui est suffisamment important pour pouvoir être exploitable.

Compte tenu de la bonne sensibilité des capteurs magnétiques utilisés, en comparaison par rapport aux capteurs électrostatiques, il n'est pas obligatoirement nécessaire que le microcomposant soit encapsulé sous vide, mais il peut au contraire fonctionner sous pression atmosphérique, ce qui simplifie le procédé de fabrication et diminue donc le coût correspondant.

Différentes architectures peuvent être employées pour réaliser à la fois l'étage d'entrée, l'équipage mobile et l'étage de sortie du composant de l'invention.

Ainsi, le bobinage métallique formant l'entrée du filtre peut être réalisé sous forme d'un solénoïde. Dans ce cas, il s'agit d'un enroulement autour d'un axe qui est généralement parallèle au plan principal du substrat sur lequel est réalisé le filtre. Le champ magnétique généré par ce bobinage d'entrée est donc parallèle au plan de ce substrat, et induit donc un déplacement de l'équipage mobile parallèlement à ce même plan.

Dans une autre forme de réalisation, le bobinage matérialisant l'entrée peut être réalisé par un enroulement plan en spirale. Dans ce cas, le bobinage peut être parallèle au plan principal du substrat, et il génère un champ magnétique qui est perpendiculaire à ce même plan. Il induit alors un champ magnétique dont les lignes de champ se referment dans des plans perpendiculaires au plan principal du substrat. Selon la position de l'équipage mobile, celui-ci peut notamment se déplacer perpendiculairement au plan principal du substrat.

Plus généralement, l'équipage mobile peut être relié au substrat par une seule portion déformable ou bien encore par deux portions déformables situées de part et d'autre de l'équipage mobile. La forme et les dimensions de ses portions déformables sont déterminées pour que les moyens de rappel présentent la raideur optimale, ainsi qu'une amplitude de mouvements suffisante et une solidité adéquate.

En pratique, l'équipage mobile peut comporter une région en un matériau ferromagnétique doux, s'aimantant sous l'effet du champ magnétique généré par le bobinage d'entrée.

Dans d'autres formes de réalisation, l'équipage mobile peut comporter une région en un matériau ferromagnétique dur formant un aimant permanent.

Dans certaines formes de réalisation, l'équipage mobile peut comporter un seul élément en matériau ferromagnétique qui d'une part subit l'influence du champ magnétique généré par le bobinage d'entrée, et d'autre part, induit un champ qui agit sur le capteur magnétique de sortie.

Dans d'autres formes de réalisation, l'équipage mobile peut comporter deux régions en matériaux fenomagnétiques, à savoir : une première région subissant la force engendrée par le champ magnétique généré par le bobinage d'entrée, et une seconde région interagissant avec l'organe de sortie.

Cet organe de sortie peut être réalisé selon différentes manières. Il peut ainsi s'agir d'un bobinage métallique relié aux bornes de sortie. Ce bobinage peut alors, à l'instar du bobinage d'entrée, être soit du type solénoïde, soit du type bobinage plan en spirale.

Dans d'autres formes de réalisation, l'organe de sortie est un capteur magnétique du type choisi dans le groupe comprenant :
■ les capteurs à effet "Hall" ;
■ les magnétomètres à portes de flux,
■ les magnétorésistances.
■ les magnétodiodes,
■ les capteurs inductifs.

En pratique, ce composant peut être intégré dans un filtre à un ou plusieurs pôles, en association avec un ou plusieurs composants du même type ou de type différent.

### Description sommaire des figures

La manière de réaliser l'invention ainsi que les avantages qui en découlent ressortiront bien de la description des modes de réalisation qui suivent, à l'appui des figures annexées dans lesquelles :
La figure 1 est une vue en perspective sommaire d'un composant conforme à l'invention réalisé selon un premier mode d'exécution.
La figure 2 est une vue de dessus du composant de la figure 1.
La figure 3 est une vue en perspective sommaire d'un microcomposant réalisé selon une deuxième variante d'exécution de l'invention.
La figure 4 est une vue de dessus du microcomposant de la figure 3.
La figure 5 est une vue en perspective sommaire d'un microcomposant réalisé selon une troisième variante d'exécution.
La figure 6 est une vue de dessus du microcomposant de la figure 5.

### Manière de réaliser l'invention

Comme évoqué ci-avant, l'invention concerne un microcomposant utilisé comme filtre, ou intégré dans un filtre à plusieurs pôles. Ce microcomposant fonctionne sur le principe de la génération d'énergie magnétique à partir d'un signal électrique, puis de la conversion de cette énergie magnétique en énergie cinétique au niveau d'un élément mobile. Cette énergie cinétique est à son tour convertie en un signal électrique par des phénomènes d'origine magnétique.

L'invention peut être mise en oeuvre en employant différentes architectures permettant d'obtenir des résultats analogues, et fonctionnant sur des principes équivalents.

### Première manière de réaliser l'invention

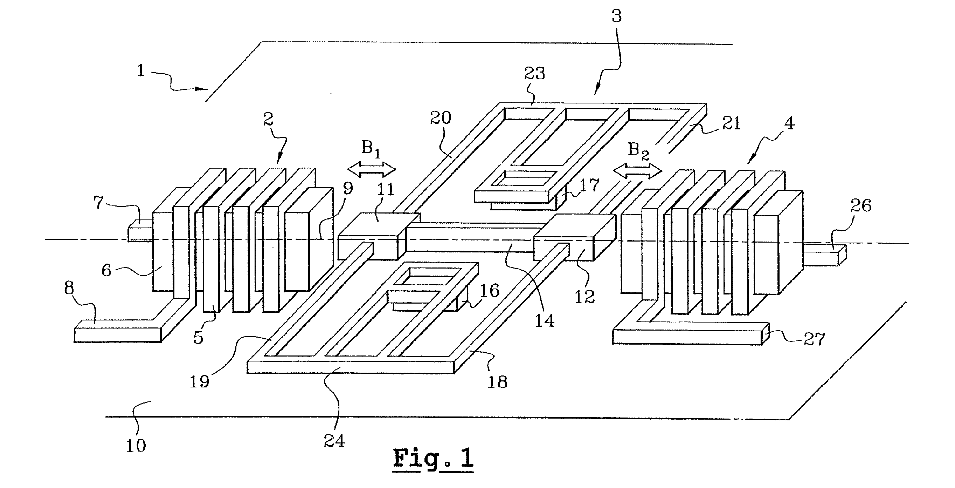

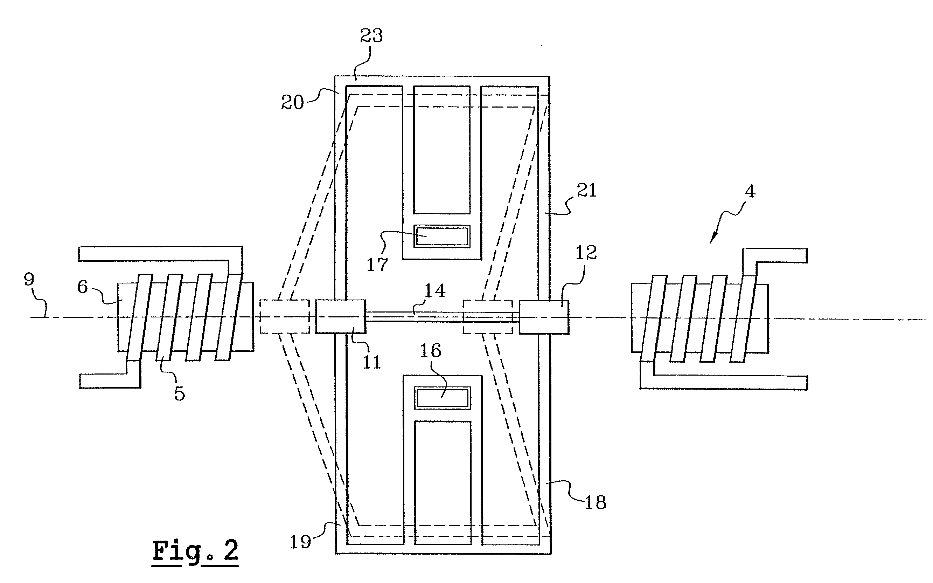

Comme illustré aux figures 1 et 2, le microcomposant peut être réalisé sur un substrat à base de matériaux semi-conducteur tels que du silicium.

Ce composant (1) comprend d'une façon principale un bobinage d'entrée (2), un équipage mobile (3) et un bobinage de sortie (4). Plus précisément, le bobinage d'entrée est réalisé sous la forme d'un solénoïde par l'enroulement de plusieurs spires métalliques (5) autour d'un noyau (6) en matériau ferromagnétique. Ces spires métalliques (5) et le noyau (6) correspondant peuvent par exemple être réalisés selon le procédé décrit dans le document EP 1 054 417 du Demandeur. Ils peuvent toutefois être réalisés selon un procédé différent. Ce solénoïde (2) comporte donc plusieurs spires (5) s'enroulant autour d'un noyau ferromagnétique (6), qui permet, par le passage de courant entre les bornes d'entrée (7, 8), de générer un champ magnétique (B₁) orienté selon l'axe du solénoïde (9), et parallèlement au plan principal du substrat (10).

L'équipage mobile (3) caractéristique de l'invention est disposé dans l'axe (9) du solénoïde d'entrée (2) et comporte dans la forme illustrée deux plots (11, 12) en matériau ferromagnétique. Ces deux plots (11, 12) sont séparés par une poutre longitudinale (14) réalisée à partir du substrat, ou par un dépôt métallique. Chacun des plots (11, 12) en matériau ferromagnétique est relié à un plot fixe (16, 17) par rapport au substrat (10), par l'intermédiaire de différentes poutres transversales et longitudinales. Plus précisément, et dans la forme illustrée, chaque plot ferromagnétique (11, 12) possède de chaque côté une poutre transversale (18, 19, 20, 21) située de part et d'autre de la poutre longitudinale centrale (4). Chaque poutre transversale (18, 21) est reliée à la poutre (19, 20) située du même côté par l'intermédiaire d'une poutre de liaison longitudinale (23, 24). Cette poutre de liaison longitudinale (23, 24) est reliée au plot fixe (16, 17) par l'intermédiaire de deux portions transversales solidaires du plot fixe par rapport au substrat (10).

Bien entendu, d'autres géométries et architectures peuvent être envisagées pour relier l'équipage mobile et plus précisément les plots ferromagnétiques (11, 12) avec les points fixes (16, 17) par rapport au substrat. Certains exemples seront décrits plus avant. L'équipage mobile (3), et plus précisément, les différentes poutres (14, 18 - 21, 23, 24) liant les plots ferromagnétiques (11, 12) avec les points fixes (16, 17) par rapport au substrat sont réalisés soit en métal, soit en polysilicium.

La structure de l'équipage mobile (3) est déformable dans un sens longitudinal, c'est-à-dire parallèlement à l'axe (9) du solénoïde d'entrée, grâce à la capacité de flexion des différentes poutres qui la composent, et notamment des poutres transversales (18-21). L'épaisseur des poutres est déterminée pour augmenter au maximum la raideur mesurée perpendiculairement au plan principal du substrat (10) ainsi que dans une direction transversale. De la sorte, le mouvement des deux plots (11, 12) en matériau ferromagnétique est quasi exclusivement dirigé selon laxe longitudinal (9) du solénoïde d'entrée (2). La figure 2 illustre un exemple de déplacement de la partie centrale de l'équipage mobile (3), entre une position de repos et une position extrémale.

Les deux plots ferromagnétiques (11, 12) situés sur l'équipage mobile (3) peuvent être de nature magnétique différente. Si ces plots sont en un matériau ferromagnétique doux, les plots subissent une force d'attraction. Si les plots sont en matériau ferromagnétique dur, ils se comportent comme un aimant permanent, avec des forces d'attraction et de répulsion.

Les deux plots (11, 12) peuvent être soit de nature identique, soit de nature différente, le plot (11) situé le plus prés du bobinage d'entrée (2) pouvant être soit en matériau ferromagnétique dur, soit en matériau ferromagnétique doux.

Le composant conforme à l'invention comporte également un bobinage de sortie (4), situé de l'autre côté de l'équipage mobile (3) par rapport au bobinage d'entrée (2). Dans la forme illustrée à la figure 1, le bobinage de sortie est de structure analogue au bobinage d'entrée. Ce bobinage de sortie (4) est relié aux bornes (26, 27) de sortie du filtre, ou bien encore incorporé dans le schéma électrique d'un filtre complémentaire, destiné à former un filtre plus complexe à pôles multiples.

Le fonctionnement du dispositif est le suivant: lorsqu'un courant électrique parcourt le bobinage d'entrée (2), il génère un champ magnétique (B₁) qui est dirigé selon l'axe longitudinal (9) du solénoïde d'entrée (2). Ce champ magnétique (B₁) crée une force électromagnétique sur le plot (11) en matériau ferromagnétique situé sur l'équipage mobile (3). Cette force est fonction du type de matériau utilisé pour le plot ferromagnétique, ainsi que de la géométrie du solénoïde, du matériau formant le noyau (9) du solénoïde, ainsi que de la géométrie du plot ferromagnétique (11). Cette force provoque la déformation de la structure de poutres (18-21) de l'équipage mobile (3), et entraîne donc le déplacement de l'équipage mobile (3) selon l'axe longitudinal (9) du solénoïde.

Le second plot (12) en matériau ferromagnétique, situé à proximité du bobinage de sortie (4) se déplace donc selon l'axe longitudinal (9) du solénoïde de sortie. Si le plot (12) est en un matériau ferromagnétique dur, et forme donc un aimant permanent, le déplacement du plot (12) engendre une variation du flux du champ magnétique (B₂) généré par le plot (12), à l'intérieur du solénoïde de sortie (4). Cette variation de flux induit une force contre-électromotrice aux bornes (26, 27) du solénoïde de sortie (4). Ce signal électrique correspond donc à la sortie du filtre, lorsque le composant est utilisé en filtre simple.

Lorsque le plot ferromagnétique (12) situé à proximité du solénoïde de sortie (4) est en un matériau ferromagnétique doux, son déplacement induit une modification du circuit magnétique du solénoïde de sortie (4), et induit donc une modification de la valeur de l'inductance de ce solénoïde. Cette variation constitue également un signal de nature électrique qui peut être exploité par un dispositif approprié.

### Deuxième manière de réaliser l'invention

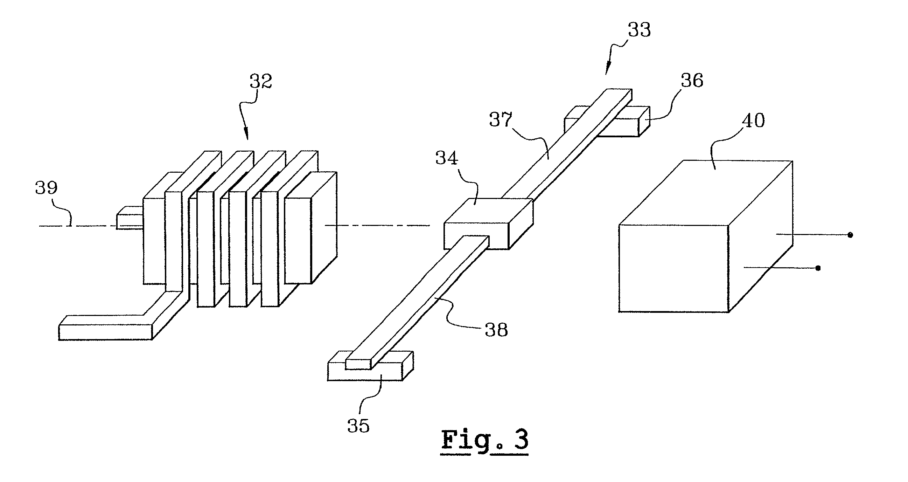

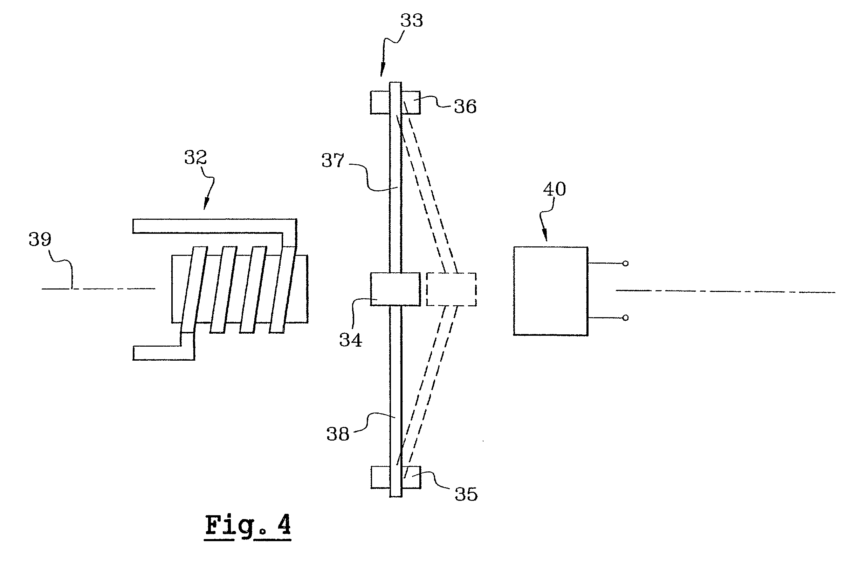

Les figures 3 et 4 illustrent une variante de réalisation dérivée de l'exemple décrit ci-avant. Dans ce cas, le bobinage d'entrée (32) est identique à celui décrit dans l'exemple précédent.

L'équipage mobile (33) est comporte un plot unique (34) en un matériau ferromagnétique dur ou doux. Ce plot ferromagnétique (34) est relié à deux points fixes (35, 36) par rapport au substrat, par l'intermédiaire de deux poutres transversales (37, 38).

Les dimensions, c'est-à-dire la longueur et les épaisseurs et la largeur des deux poutres (37, 38) sont déterminées pour que la raideur soit minimale selon l'axe longitudinal (39) du solénoïde d'entrée (32). Dans une forme particulière non représentée, l'équipage mobile peut n'être relié au substrat par l'intermédiaire d'une seule poutre transversale.

L'étage de sortie du filtre des figures 3 et 4 peut être réalisé par différents types de capteurs magnétiques (40), sensibles au déplacement du plot en matériau ferromagnétique.

### Troisième manière de réaliser l'invention

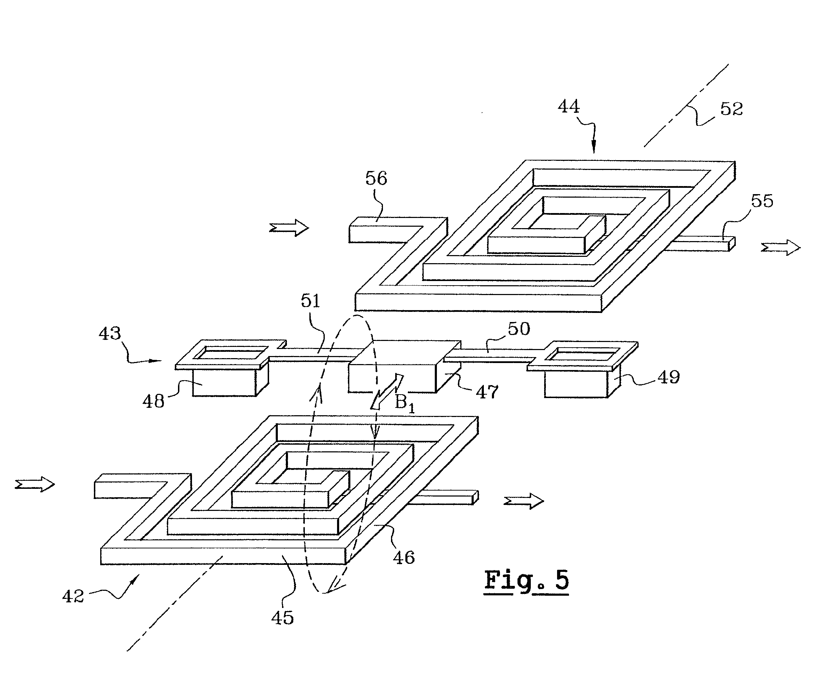

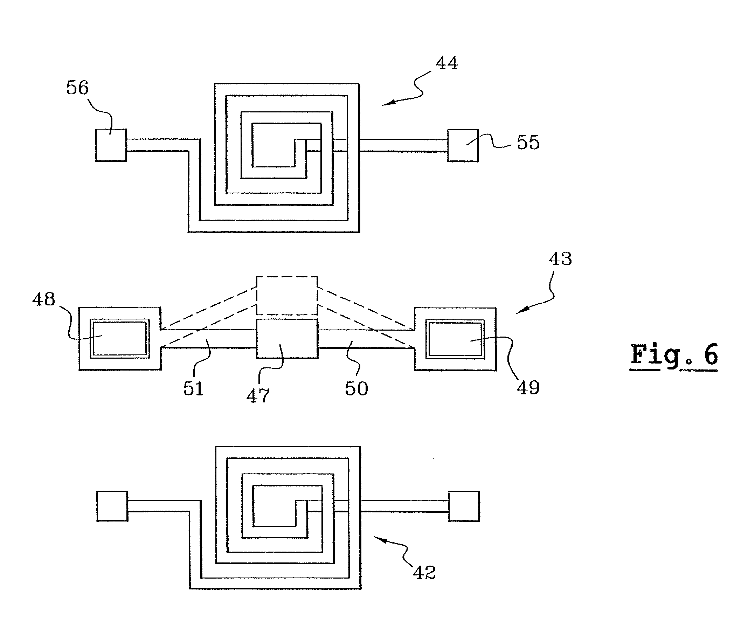

Les figures 5 et 6 illustrent un autre mode de réalisation de l'invention dans lequel les bobinages d'entrée et de sortie sont réalisés différemment.

Plus précisément, le bobinage d'entrée (42) est réalisé sous forme d'un enroulement plan en spirale. Cet enroulement possède plusieurs segments (45, 46) parallèles et perpendiculaires qui peuvent être réalisés notamment selon les enseignements du document EP 1 039 544 du Demandeur. Néanmoins, un tel enroulement en spirale peut également être obtenu selon des procédés différents.

Dans cette configuration, lorsque le bobinage d'entrée (42) est parcouru par un courant, il génère un champ magnétique (B₁) qui est perpendiculaire au plan du substrat (10) dans la partie centrale de la bobine (42), et dont les lignes de champ en traversent le plan principal du substrat à l'extérieur du bobinage.

Le bobinage de sortie (44) est réalisé de la même manière que le bobinage d'entrée (42), par un enroulement plan en spirale, situé dans le même plan que celui du bobinage d'entrée (42).

Entre les deux bobinages d'entrée et de sortie, le composant comporte l'équipage mobile caractéristique (43) qui, dans la forme illustrée, comprend un plot (47) en un matériau ferromagnétique relié à deux points fixes (48, 49) par rapport au substrat, par l'intermédiaire de deux poutres (50, 51).

Plus précisément, le plot magnétique (47) est situé légèrement au-dessus du plan formé par les deux bobinages d'entrée (42) et de sortie (44). De la sorte, lorsqu'un courant parcourt le bobinage d'entrée (42), un champ magnétique est généré, illustré par la flèche (B₁) de la figure 5. Ce champ magnétique, en interagissant avec le plot ferromagnétique (47) génère une force sur ce plot dont une composante est située dans le plan principal du substrat (10), et plus précisément qui est parallèle à la direction (52) reliant les deux centres des bobinages plans (42, 44).

Il s'ensuit que le plot ferromagnétique (47) se déplace parallèlement à la direction précitée (52), à la fréquence du courant parcourant le bobinage d'entrée (42).

La géométrie des différentes poutres (50, 51) reliant le plot ferromagnétique (47) aux points fixes (48, 49) est déterminée pour que la raideur soit maximale dans la direction perpendiculaire au substrat (10) afin que le plot ferromagnétique se déplace effectivement entre les deux bobinages plans (42, 44).

Lorsque le plot ferromagnétique (47) se déplace sous l'influence du champ généré par le bobinage d'entrée (42), il provoque une variation de flux du champ magnétique qu'il génère à l'intérieur du bobinage de sortie (44). Il s'ensuit l'apparition d'une force contre électromotrice entre les bornes (55, 56) du bobinage de sortie (44), qui constitue le filtrage du signal d'entrée.

Lorsque le plot ferromagnétique est en un matériau ferromagnétique doux, il génère également une variation de l'inductance du bobinage plan de sortie (44), qui peut être exploitée par un dispositif approprié.

Il ressort de ce qui précède que les composants conformes à l'invention présentent de multiples avantages, et notamment celui de conserver une bonne amplitude de déplacement de l'équipage mobile, même dans les fréquences élevées de la gamme employée, ce qui permet d'obtenir un signal de sortie d'amplitude suffisante pour une exploitation satisfaisante.

## Revendications

1. Composant microélectromécanique (1) assurant des fonctions de filtrage, réalisé sur un substrat (10) à base de matériau semi-conducteur, et comportant deux bornes d'entrée (7, 8) et deux bornes de sortie (26, 27), **caractérisé en ce qu'**il comporte également :
■ un bobinage métallique d'entrée (2), relié aux bornes d'entrée (7, 8), et apte à générer un champ magnétique lorsqu'il est parcouru par un courant ;
■ un équipage mobile (3). relié au substrat par au moins une portion déformable, et incluant au moins une région (11, 12) réalisée en un matériau ferromagnétique, ledit équipage mobile (3) étant apte à se déplacer sous l'effet de la force subie par la région (11) en matériau ferromagnétique engendrée par le champ magnétique généré par le bobinage d'entrée (2) ;
■ un organe de sortie (4) formant un capteur magnétique, relié aux bornes de sortie (26, 27) et apte à générer un signal de nature électrique qui est variable en fonction du déplacement de l'équipage mobile (3).

2. Composant selon la revendication 1, **caractérisé en ce que** le bobinage métallique d'entrée (2) est de type solénoïde.

3. Composant selon la revendication 1, **caractérisé en ce que** le bobinage métallique d'entrée (32) est de type bobinage plan en spirale.

4. Composant selon la revendication 1, **caractérisé en ce que** l'équipage mobile est relié au substrat par une seule portion déformable.

5. Composant selon la revendication 1, **caractérisé en ce que** l'équipage mobile (3) est relié au substrat par deux portions déformables (18-21, 23, 24), situées de part et d'autre de l'équipage mobile.

6. Composant selon la revendication 1, **caractérisé en ce que** l'équipage mobile comporte une région (11, 12) en matériau ferromagnétique doux, s'aimantant sous l'effet du champ magnétique généré par le bobinage d'entrée.

7. Composant selon la revendication 2, **caractérisé en ce que** l'équipage mobile comporte une région en matériau ferromagnétique dur (11, 12), formant aimant permanent.

8. Composant selon la revendication 1, **caractérisé en ce que** l'équipage mobile comporte deux régions en matériau ferromagnétique, à savoir :
■ une première région (11) subissant la force engendrée par le champ magnétique généré par le bobinage d'entrée (2) ;
■ une seconde région (12) interagissant avec l'organe de sortie (4).

9. Composant selon la revendication 1, **caractérisé en ce que** l'organe de sortie (4) est un bobinage métallique relié aux deux bornes de sortie.

10. Composant selon les revendications 2 et 9, **caractérisé en ce que** le bobinage métallique de sortie (4) est de type solénoïde.

11. Composant selon les revendications 3 et 9, **caractérisé en ce que** le bobinage métallique de sortie (44) est de type bobinage plan en spirale.

12. Composant selon la revendication 1, **caractérisé en ce que** l'organe de sortie (40) est un capteur magnétique du type choisi dans le groupe comprenant :
■ les capteurs à effet "Hall" ;
■ les magnétomètres à portes de flux,
■ les magnétorésistances.
■ les magnétodiodes
■ les capteurs magnéto-inductifs.
